# EUROPÄISCHE PATENTSCHRIFT

(11) **EP 1 634 125 B1**
(45) Veröffentlichungstag und Bekanntmachung des Hinweises auf die Patenterteilung: **25.07.2007**
(21) Anmeldenummer: 04739268.3
(22) Anmeldetag: 19.05.2004
(51) Int. Cl.: G03F 7/11, G03F 7/42, B81C 1/00

(54) **LITHOGRAPHISCHES VERFAHREN ZUR HERSTELLUNG VON MIKROBAUTEILEN**
LITHOGRAPHIC METHOD FOR PRODUCING MICROCOMPONENTS
PROCEDE LITHOGRAPHIQUE DE FABRICATION DE MICROCOMPOSANTS

(30) Priorität: 23.05.2003 DE 10323350
(43) Veröffentlichungstag der Anmeldung: 15.03.2006
(73) Patentinhaber: Singleton, Laurence, 01099 Dresden (DE)
(72) Erfinder: SINGLETON, Laurence, 01099 Dresden (DE); SCHEURER, Jörg, 53121 Bonn (DE)
(74) Vertreter: Lippert, Stachow & Partner
(86) Internationale Anmeldenummer: PCT/EP2004/005428
(87) Internationale Veröffentlichungsnummer: WO 2004/104704

(56) Entgegenhaltungen:
- DE-A1- 10 021 489
- DE-A1- 19 955 969
- DE-A1- 19 955 975

## Beschreibung

Die Erfindung betrifft ein lithographisches Verfahren zur Herstellung von Mikrobauteilen mit Bauteilstrukturen im Sub-Millimeterbereich.

Derartige lithographische Verfahren werden zur Herstellung unterschiedlichster insbesondere metallischer Mikrobauteile verwendet. Je nach Einsatzzweck müssen die Mikrobauteile eine hohe Strukturdichte bei gleichzeitig relativ großer Strukturhöhe aufweisen.

Bei lithographischen Verfahren werden unterschiedliche Polymere als Resistmaterialien zur Herstellung von Strukturen für die metallische Abscheidung verwendet, wobei unter Resistmaterialien solche verstanden werden, die mittels Belichtung strukturierbar sind.

PMMA als Resistmaterial ist zwar am weitesten verbreitet, hat aber den Nachteil, dass zur Herstellung von Mikrostrukturen mit Aspektverhältnissen >10 für die Belichtung Synchrotronstrahlung eingesetzt werden muss, was einerseits sehr zeitaufwendig und andererseits mit hohen Kosten verbunden ist.

Es wurde daher versucht, auf photostrukturierbare Resistmaterialien überzugehen, die beispielsweise mittels UV-Licht strukturierbar sind. Diese Materialien haben jedoch in der Regel den Nachteil, dass keine großen Aspektverhältnisse erzielt werden können.

Ein Resistmaterial, das sowohl große Aspektverhältnisse von beispielsweise 15 und darüber ermöglicht, als auch mittels UV-Licht strukturiert werden kann, ist Epoxyharz, insbesondere ein Epoxyderivat eines Bis-Phenol-A-Novolacs, das bisher bereits in der Halbleitertechnik verwendet wurde. Dieses Resistmaterial wird als SU-8-Resistmaterial (Handelsname der Shell Chemical) verwendet, das beispielsweise in J. Micromechanics, Microengineering 7(1997) S. 121-124 beschrieben wird. Große Aspektverhältnise können dadurch hergestellt werden, dass aufgrund der Vernetzung bei der Belichtung eine Veränderung des Brechungsindex dieses Materials erzeugt wird, so dass aus dem Resistmaterial Strukturen mit Wellenleitereigenschaften hergestellt werden können. Man erhält dadurch bei der Belichtung mittels Masken letztendlich senkrechte Wände, die beim Herausätzen der unbelichteten Bereiche erhalten bleiben.

SU-8-Material hat jedoch den Nachteil, dass die Entfernung von vernetzten SU-8-Resiststrukturen zwischen galvanisch abgeschiedenen Metallstrukturen derzeit ein sehr aufwendiger Prozess ist. Da das Resistmaterial ein Epoxyresist ist, ist es im vernetzten Zustand sehr stabil gegen organische oder anorganische Ätzmittel. Die üblichen Ätzmittel NMP, Methylenchlorid, KOH, Salpetersäure und H₂O₂/H₂SO₄ haben eine begrenzte Wirkung auf die vernetzten Resiststrukturen. Für die anorganischen Ätzmittel sind die metallischen Mikrostrukturen längst weggeätzt, bevor irgendeine Wirkung auf die SU-8-Resiststrukturen erkennbar ist. Dem gegenüber ätzen die organischen Stoffe die Resiststruktur nicht, sondern sie quellen das vernetzte Resistmaterial lediglich auf, wodurch sie nur eingeschränkt zur Resistentfemung dienen können. Diese organischen Ätzmittel taugen daher nur für sehr niedrige Höhen, d.h. sehr geringe Aspektverhältnisse.

Es ist bekannt, dass SU-8-Strukturen auch durch Plasmaätzen, Verbrennung, heiße Salzbäder oder Zerquellen mit organischen Lösungsmitteln entfernt werden kann. Das Zerquellen funktioniert nur für sehr niedrige Aspektverhältnisse und sehr niedrige Resistdicken <50 µm.

Das SU-8-Material lässt sich nur dann leicht ablösen, wenn es unmittelbar auf der Waferoberfläche aufgebracht ist. Für Resiststrukturen, die nicht zwischen galvanisch abgeschiedenen Metallstrukturen liegen, ist daher ihre Entfernung von der Oberfläche durch ein organisches Ätzmittel relativ einfach. Wenn der Wafer aber metallisiert ist, kann das organische Ätzmittel die Waferoberfläche unter den Resiststrukturen nicht erreichen, weil die Galvanikstruktur die Strukturen schützen und den Zugang der Ätzmittel zur Oberfläche erschweren.

Das Plasmaätzen kann ebenfalls nur für niedrige Resisthöhen verwendet werden, wobei das Plasma auch das Metall angreift.

Die Verbrennung läuft erst ab 600°C ab, wodurch die Metallstrukturen beschädigt werden.

Anorganische Ätzmittel (HNO3) beschädigen die Metallschichten.

Die bisher bekannten Verfahren zum Entfernen von SU-8-Material sind in Paul M. Dentinger "Removal of SU-8 Photoresist for Thick Film Applications, Microelectronic Engineering, 61-62, 2002, S. 993, beschrieben.

Es ist daher Aufgabe der Erfindung, ein lithographisches Verfahren zur Herstellung von Mikrobauteilen bereitzustellen, bei dem das Herauslösen des Resistmaterials auf einfache Weise möglich ist.

Diese Aufgabe wird mit einem lithographischen Verfahren zur Herstellung von Mikrobauteilen mit Bauteilstrukturen im Sub-Millimeterbereich gelöst, bei dem auf eine metallische Startschicht eine strukturierbare Haftschicht aufgebracht und strukturiert und auf die Haftschicht eine Schicht aus photostrukturierbarem Epoxyharz aufgebracht wird, das Epoxyharz mittels selektiver Belichtung und Herauslösen der unbelichteten Bereiche zur Ausbildung von Stützstrukturen und Freiräumen zwischen den Stützstrukturen strukturiert wird, anschließend die für das Mikrobauteil vorgesehenen Freiräume zwischen den Epoxyharzstrukturen mittels eines galvanischen Verfahrens mit Metall aufgefüllt werden und schließlich das Epoxyharz entfernt wird, und das dadurch gekennzeichnet ist, dass bei der Strukturierung des Epoxyharzes eine Rahmenstruktur mit Stützwänden sowie zwei Gruppen von Freiräumen geschaffen werden, anschließend nur die erste Gruppe von Freiräumen mit Metall zur Ausbildung des Mikrobauteils gefüllt wird und schließlich in die zweite Gruppe von Freiräumen zur Entfernung des Epoxyharzes Ätzmittel eingebracht wird.

Bei der Ausbildung der Stützstrukturen werden nicht nur Freiräume gebildet, die anschließend mit Metall aufgefüllt werden und somit für das spätere Mikrobauteil vorgesehen sind, sondern es werden auch zusätzliche Freiräume geschaffen, die nicht mit Metall aufgefüllt werden und während des galvanischen Verfahrens frei bleiben. Es werden dadurch Ätzkammern gebildet, in die Ätzmittel eingebracht wird, wodurch die Stützstruktur leichter herausgelöst werden kann.

Es werden daher zwei Gruppen von Freiräumen geschaffen, wobei die erste Gruppe von Freiräumen mit Metall zur Ausbildung des Mikrobauteils gefüllt werden und die zweite Gruppe von Freiräumen die Ätzkammern bilden. Mit dieser Art der Strukturierung wird eine Rahmenstruktur mit Stützwänden geschaffen, die die erste Gruppe von Freiräumen umgibt. Die Startschichten der Freiräume der ersten Gruppe stehen in der Regel miteinander in Verbindung.

Da die Haftschicht nach ihrem Aufbringen die metallische Startschicht für den Galvanikprozess vollständig abdeckt, ist eine Strukturierung notwendig, wobei die Freilegung der Startschicht dort vorgenommen werden muss, wo nach der Strukturierung des Epoxyharzes die erste Gruppe der Freiräume gebildet wird.

Für die Strukturierung der Haftschicht gibt es vorzugsweise zwei Varianten.

Gemäß der ersten Variante wird die Haftschicht vor dem Aufbringen des Epoxyharzes strukturiert.

Bei Verwendung einer photostrukturierbaren Haftschicht kann die Struktur unter Einsatz einer Maske selektiv belichtet werden, wobei die unbelichteten Bereiche anschließend entfernt werden.

Gemäß der zweiten Variante wird die Haftschicht nach dem Aufbringen des Epoxyharzes und dem Entfernen der unbelichteten Bereiche des Epoxyharzes strukturiert. Nach dem Entfernen der unbelichteten Bereiche liegen sowohl die Freiräume der ersten als auch der zweiten Gruppe frei. Im nächsten Schritt wird daher die Haftschicht lediglich dort, wo die erste Gruppe der Freiräume vorgesehen ist, entfernt, wobei vorzugsweise diese Entfernung mittels Plasmaätzen oder Laserbearbeitung durchgeführt wird.

Vorzugsweise wird für die Haftschicht ein Polyimid verwendet.

Als Polyimide bzw. photostrukturierbare Polyimide kommen solche in Frage, die in TRIP. Vol. 3, Nr. 8, August 1995, S. 262 - 271, "The Synthesis of Soluble Polyimides" von Samual J. Huang und Andrea E. Hoyt sowie in SPIE Vol. 1925, S. 507 - 515 "Base-Catalyzed Photosensitive Polyimide" von Dennis R. McKean et al. beschrieben werden. Mischungen dieser Polyimide sind ebenfalls als Haftschicht geeignet. Insbesondere können Polyimide mit den Marken Durimide 7020 und Probimide 7020 von der Firma Arch Semiconductors Chemicals verwendet werden.

Vorzugsweise wird als Epoxyharz SU8® verwendet. SU8-Material hat den Vorteil, dass besonders große Aspektverhältnisse realisiert werden. Der Nachteil des SU8-Materials besteht allerdings darin, dass es nur schwer herausgelöst werden kann.

Das Verfahren ist daher besonders für die Verwendung von SU8-Material geeignet, weil die Wandstärke der Stützstrukturen an die Eigenschaften des Materials der Stützstruktur angepasst werden kann und Ätzkammern während des Strukturierungsprozesses angelegt werden. Unter Berücksichtigung der jeweiligen Bauhöhen der Mikrobauteile und der dafür notwendigen Stabilität der Stützstrukturen kann die Wandstärke so gewählt werden, dass sie sich später leicht entfernen lässt. Es können somit Mikrobauteile mit Strukturen hergestellt werden, die mit den herkömmlichen Verfahren nicht gefertigt werden können.

Vorzugsweise wird die Wandstärke der Wände der Stützstrukturen so gewählt, dass das Aspektverhältnis der Wände ≤20 beträgt. Besonders bevorzugt ist ein Aspektverhältnis ≤10, und zwar dann, wenn eine besonders große Stabilität erforderlich ist.

Damit das Herauslösen des Epoxyharzes überall gleich schnell erfolgt, **wird die Wandstärke aller Wände vorzugsweise gleich stark gewählt. Es** gibt somit keine Bereiche, wo der Ätzvorgang länger dauert als in anderen Bereichen, so dass die Fertigung von Mikrobauteilen hinsichtlich ihres zeitlichen Ablaufs und Zeitbedarfs exakt kalkuliert werden kann.

Vorzugsweise werden mit dem Verfahren folgende Mikrobauteile hergestellt: metallische Mikrobauteile, Spulen, magnetische Mikrostrukturen, Bauteile für RF-Signalerzeugung.

Beispielhafte Ausführungsformen der Erfindung werden nachfolgend anhand der Zeichnungen näher erläutert.

Es zeigen
- Fig. 1 a-f: Verfahrensschritte zur Herstellung eines Mikrobauteils gemäß einer ersten Ausführungsform,
- Fig. 2 a-e: Verfahrensschritte zur Herstellung eines Mikrobauteils gemäß einer zweiten Ausführungsform,
- Fig. 3: eine Draufsicht auf das Zwischenprodukt nach Schritt e) in Fig. 1, und
- Fig. 4: eine Draufsicht auf das fertige Mikrobauteil.

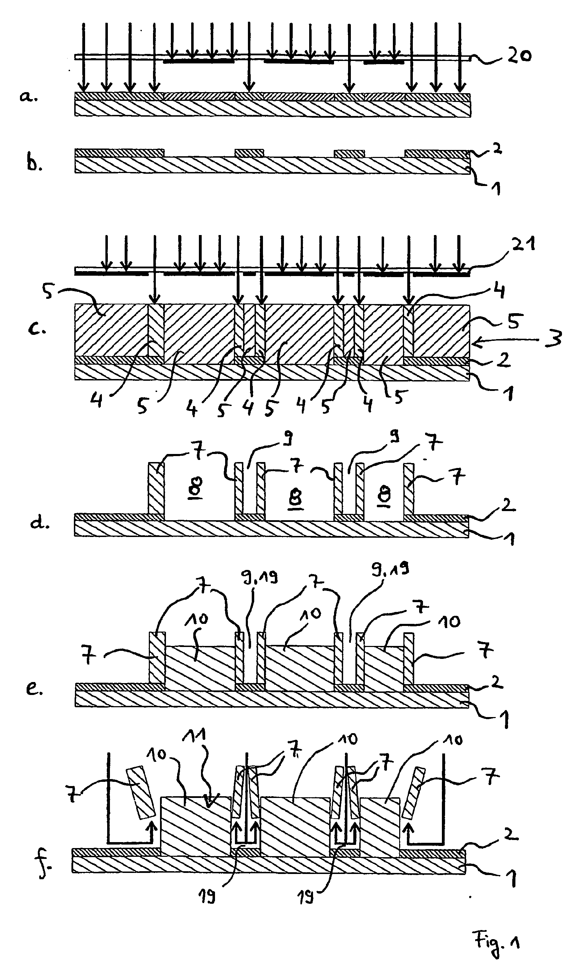

In der Fig.1 wird anhand der Verfahrensschritte a-f die Herstellung eines Mikrobauteils 11 (Fig. 4) schematisch erläutert.

Im Verfahrensschritt a wird die auf einem Substrat 1, das aus einer metallischen Startschicht besteht, die darauf aufgebrachte Haftschicht 2, vorzugsweise aus einem Polyimid, mittels einer Maske 20 und entsprechender Belichtung strukturiert.

Im Schritt b sind die unbelichteten Bereiche zur Freilegung des Substrates 1 entfernt worden. Die Strukturierung der Haftschicht 2 wurde so gewählt, dass das Substrat 1 jeweils in den Bereichen freigelegt wird, wo nach der Strukturierung der anschließend aufzubringenden Resistschicht 3 die erste Gruppe von Freiräumen 8 ausgebildet wird.

Im Schritt c wird die Resistschicht 3 aus einem Epoxyharzmaterial, vorzugsweise aus SU-8-Material, aufgebracht und mittels einer weiteren Maske 21 und entsprechender Belichtung strukturiert. Die belichteten Bereiche befinden sich auf der Haftschicht 2, während die unbelichteten Bereiche sich sowohl auf der Haftschicht 2 als auch im Bereich des freigelegten Substrates 1 befinden.

Im nachfolgenden Verfahrensschritt d werden die unbelichteten Bereiche 5 der Resistschicht 3 entfernt, wodurch die Stützstruktur 6 gebildet wird. Die Stützstruktur 6 besteht aus den belichteten und ausgehärteten Bereichen des Resistmaterials, wodurch eine Rahmenstruktur 6 mit Stützwänden 7 gebildet wird. Zwischen den Stützwänden 7 werden Freiräume geschaffen, die in zwei Gruppen zu unterteilen sind. Diejenigen Freiräume, die sich auf den freigelegten Substratbereichen befinden, werden als erste Gruppe von Freiräumen 8 bezeichnet und sind diejenigen Freiräume, die im nachfolgenden Verfahrensschritt e mit Metall zur Ausbildung des Mikrobauteils 11 gefüllt werden. Die zweite Gruppe von Freiräumen 9 befindet sich auf der Haftschicht 2 und dient schließlich als Ätzkammern 19.

Der Verfahrensschritt e zeigt, dass in die Freiräume 8 der ersten Gruppe die Metallschicht 10 mittels eines galvanischen Verfahrens eingebracht wird. Hierbei werden die Freiräume 9 der zweiten Gruppe auf geeignete Weise (nicht dargestellt) abgedeckt bzw. wird aufgrund der nicht freiliegenden Substratschicht, die als Startschicht dient, in den Freiräumen 9 ohnehin kein Metall abgeschieden. Diese so gebildeten Ätzkammern 19 werden im nachfolgenden Verfahrensschritt f mit dem Ätzmittel gefüllt, so dass sich die Stützwände 7 auf einfache Weise herauslösen lassen.

Die einzelnen Verfahrensschritte sind unter Angabe der verwendeten Materialien in der nachfolgenden Tabelle zusammengefasst

| Wafer dehydrieren | |
|---|---|
| Polyimid Schicht aufschleudern | Probimide 7020 |
| | Verdünnt mit n-Methyl-Pyrrolidon (3:1) |
| | Auftrag: 5 ml |
| | |
| | Spinncoaten |
| | Resistdicke ≈300 nm |
| Trocknung der Polyimidschicht | 1.) 90°C / 4 min |
| | 2.) 110°C / 4 min |
| Justierte Belichtung | Maske 20 |
| | Anlage: MA 56, Softkontakt, Negativlack |
| | 100 mJ/cm² (405m) |
| Thermische Behandlung | 110°C |
| (post exposure bake) | 2 mins |
| Polyimidschicht entwickeln: | Entwickler für Polyimid 45 s |
| | waschen mit Entwickler |
| | Waschen mit Waschlösung |
| | Isopropanol 60s |
| Imidisierung, Vernetzung | 380°C, 1 Stunde |
| | langsam Abkühlen unter N₂-Durchftuß |
| SU-8 Resist aufschleudern | Resisthöhe ca. 160 µm |
| | SU-8 50 |
| SU-8 Trocknung | 95°C, 6 h |
| SU-8 Resist belichten | Maske 21 |
| | Dosis 1200 mJ/cm² |
| SU-8 thermische Behandlung | Heizplatte |
| (post exposure bake) | 1) 50°C, 2 min. |
| | 2) 95°C, 12 mins |
| | 3) langsam abkühlen |
| SU-8 entwickeln | Propylenglykolmonoaetheracetat |
| | Bad 1 : 20 min. |
| | Bad 2 : 20 min. |
| Galvanik | |
| SU-8 Entlackung | Su8-Entfemer, Entlacker n-Methyl-Pyrrolidon |
| | Tempratur 80°C |
| | Ultraschall |

In diesem Beispiel wurden Aspektverhältnisse von 2 erzielt.

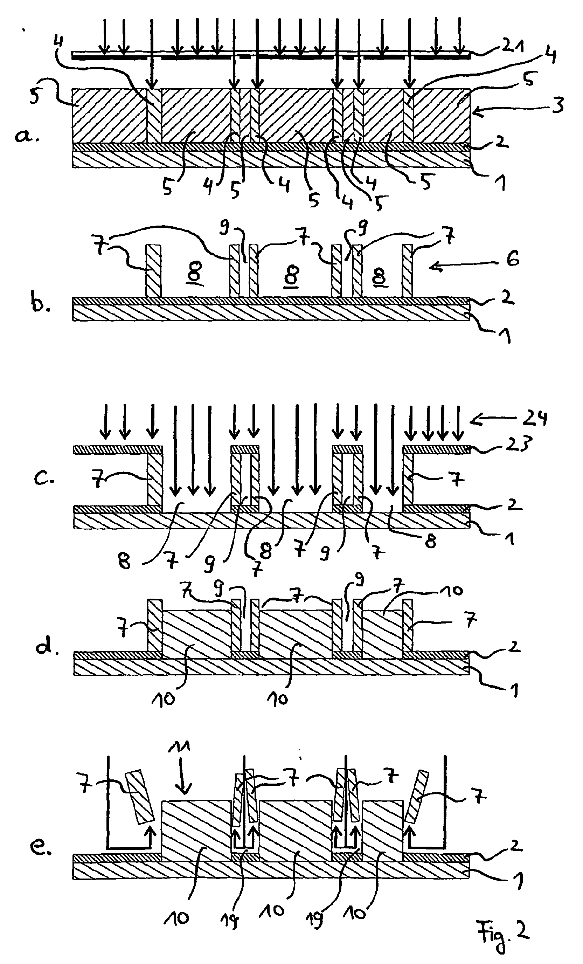

In der Fig. 2 ist eine Alternative des zuvor beschriebenen Herstellungsverfahrens schematisch dargestellt.

Im Verfahrensschritt a ist das Substrat 1 mit einer Haftschicht 2 versehen, die vor dem Aufbringen der Resistschicht 3 noch nicht strukturiert worden ist. In diesem Beispiel wird zunächst die Strukturierung der Resistschicht 3 mittels der Maske 21 durchgeführt, so dass belichtete Bereiche 4 und unbelichtete Bereiche 5 entstehen.

Im nachfolgenden Verfahrensschritt b werden die unbelichteten Bereiche 5 der Resistschicht 3 entfernt, so dass Freiräume 8 und 9 geschaffen werden.

Da die Strukturierung der Haftschicht in den Freiräumen 8 der ersten Gruppe noch nicht erfolgt ist, wird dies im Verfahrensschritt c mittels eines Plasmas 24 durchgeführt. Damit die Bereiche der Freiräume 9 der zweiten Gruppe nicht mit dem Plasma beaufschlagt werden, ist eine entsprechende Maske 23 vorgesehen, mit der diese Freiräume 9 abgedeckt werden.

Alternativ ist es auch möglich die Haftschicht mittels Laserbearbeitung zu strukturieren. In diesem Fall kann auf die Maske 23 verzichtet werden.

Im nachfolgenden Verfahrensschritt d werden die Freiräume 8 der ersten Gruppe mit der Metallschicht 10 mittels eines galvanischen Verfahrens aufgefüllt. Die Freiräume 9 werden wegen fehlender Startschicht nicht mit Metall ausgefüllt.

Im Verfahrensschritt e wird in die durch die Freiräume 9 gebildeten Ätzkammern 19 Ätzmittel eingebracht und auf diese Weise die Stützwände 7 entfernt.

In den Fign. 1 und 2 ist die Wirkung des Ätzmittels durch die Pfeile angedeutet.

Das Ätzmittel wird in beiden Verfahrensvarianten auch an die Außenwände 7 herangebracht, wie dies ebenfalls durch die jeweiligen Pfeile dargestellt ist. Insofern wird das Ätzmittel nicht nur in die Ätzkammern 19 eingefüllt.

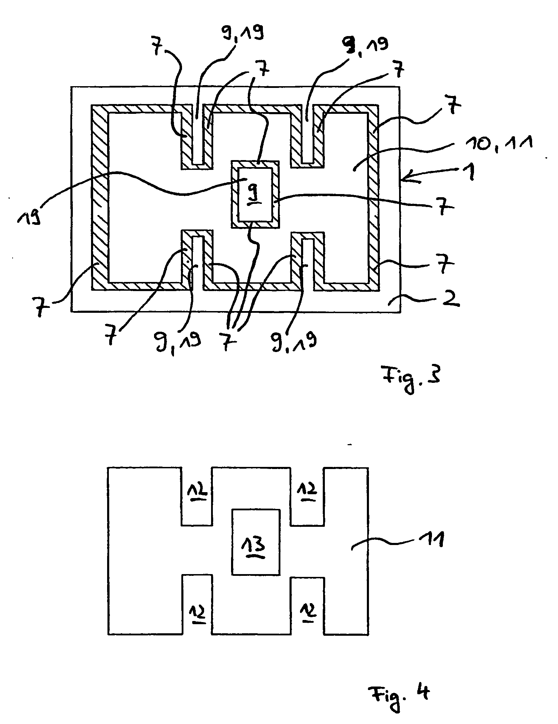

In der Fig. 3 ist die Draufsicht auf das Zwischenprodukt gemäß des Verfahrensschrittes e dargestellt. Die Darstellung 1 e ist ein Schnitt durch das Zwischenprodukt der Fig. 3 längs der Linie I-I.

Es ist in der Fig. 3 zu sehen, dass die Stützwände 7 eine das spätere Mikrobauteil 11 umgebende Rahmenstruktur 6 bilden, wobei die Wandstärke der Wände 7 überall gleich ist. Dieses Mikrobauteil 11 weist vier Ausnehmungen 12 und eine zentrale Öffnung 19 auf (s. Fig. 4), so dass in dem hier gezeigten Beispiel vier von außen zugängliche Ätzkammern 19 und eine zentrale Ätzkammer 19 ausgebildet wird. Bei den herkömmlichen Verfahren wären die Freiräume 9 vollständig mit Resistmaterial ausgefüllt, so dass für das Ätzmittel lediglich von außen Angriffsflächen vorhanden wären, um das Resistmaterial herauszulösen. Dies würde in den relativ dicken Bereichen der Ausnehmungen 12 und der Öffnung 13 zu erheblichen Problemen führen bzw. es würde eine relativ lange Zeit dauern, bis das Resistmaterial aus diesen Bereichen herausgelöst ist. Aufgrund des Vorsehens der Ätzkammern 19 ist die Wandstärke überall gleich oder nahezu gleich, so dass der Ablöseprozeß in allen Bereichen der Rahmenstruktur gleich schnell erfolgt.

In der Fig. 4 ist die Draufsicht des fertigen Mikrobauteils 11 zu sehen.

### Bezugszeichen

- 1: Substrat
- 2: Haftschicht
- 3: Resistschicht
- 4: belichteter Resistbereich
- 5: unbelichteter Resistbereich
- 6: Stützstruktur
- 7: Wand
- 8: erster Freiraum
- 9: zweiter Freiraum
- 10: Metallschicht
- 11: Mikrobauteil
- 12: Ausnehmung
- 13: Öffnung
- 19: Ätzkammer
- 20: Maske
- 21: Maske
- 22: Maske
- 23: Maske
- 24: Plasma

## Patentansprüche

1. Lithographisches Verfahren zur Herstellung von Mikrobautei-1en (11) mit Bauteilstrukturen im Sub-Millimeterbereich, bei dem auf eine metallische Startschicht (1) eine strukturierbare Haftschicht (2) aufgebracht und strukturiert und auf die Haftschicht (2) eine Schicht aus photostrukturierbarem Epoxyharz (3) aufgebracht wird, das Epoxyharz (3) mittels selektiver Belichtung (4) und Herauslösen der unbelichteten Bereiche (5) zur Ausbildung von Stützstrukturen (6) und Freiräumen (8,9) zwischen den Stützstrukturen (6) strukturiert wird, anschließend die für das Mikrobauteil (11) vorgesehenen Freiräume (8) zwischen den Epoxyharzstützstrukturen (6) mittels eines galvanischen Verfahrens mit Metall (10) aufgefüllt werden, und schließlich das Epoxyharz (3) entfernt wird, **dadurch gekennzeichnet, dass** bei der Strukturierung des Epoxyharzes (3) eine Rahmenstruktur (6) mit Stützwänden (7) sowie zwei Gruppen von Freiräumen (8,9) geschaffen werden, anschließend nur die erste Gruppe von Freiräumen (8) mit Metall (10) zur Ausbildung des Mikrobauteils (11) gefüllt wird und schließlich in die zweite Gruppe von Freiräumen (9) zur Entfernung des Epoxyharzes (3) Ätzmittel eingebracht wird.

2. Verfahren nach Anspruch 1, **dadurch gekennzeichnet, dass** die Haftschicht (2) vor dem Aufbringen des Epoxyharzes (3) strukturiert wird.

3. Verfahren nach Anspruch 1, **dadurch gekennzeichnet, dass** die Haftschicht (2) nach dem Aufbringen des Epoxyharzes (3) und Entfernen der unbelichteten Bereiche (5) des Epoxyharzes (3) strukturiert wird.

4. Verfahren nach Anspruch 3, **dadurch gekennzeichnet, dass** die Haftschicht (2) mittels Plasmaätzen strukturiert wird.

5. Verfahren nach einem der Ansprüche 1 bis 4, **dadurch gekennzeichnet, dass** für die Haftschicht (2) ein Polyimid verwendet wird.

6. Verfahren nach einem der Ansprüche 1 bis 5, **dadurch gekennzeichnet, dass** als Epoxyharz (3) ein Epoxyderivat eines Bis-Phenol-A-Novolacs, insbesondere SU8-Material, verwendet wird.

7. Verfahren nach einem der Ansprüche 1 bis 6, **dadurch gekennzeichnet, dass** die Wandstärke der Wände (7) der Stützstrukturen (6) so gewählt wird, dass das Aspektverhältnis der Wände < 20 beträgt.

8. Verfahren nach Anspruch 7, **dadurch gekennzeichnet, dass** die Wandstärke der Wände (7) der Stützstrukturen (6) so gewählt wird, dass das Aspektverhältnis < 10 beträgt.

9. Verfahren nach einem der Ansprüche 1 bis 8, **dadurch gekennzeichnet, dass** die Wandstärke aller Wände (7) gleich stark gewählt wird.

## Claims

1. A lithographic process for the manufacturing of microcomponents (11) having component structures in the sub-millimetre range, wherein a structurable adhesion layer (2) is applied onto a metallic seed layer (1) and structured, and onto the adhesion layer, a layer of photostructurable epoxy resist (3) is deposited, which, through selective irradiation (4) and development of the non-irradiated areas (5), is used for the creation of support structures (6) and free areas (8, 9) between the support structures, and then the free areas (8) between the epoxy resist structures (6), which are designated for said microcomponent (11), are filled with metal (10) by an electroplating process, and finally, the epoxy resist material (3) is removed, **characterized in that** during the structuring of the epoxy resist (3) a scaffold structure (6) with support structures (7) is created with two types of free areas (8, 9), although only the first group of free areas (8) is filled with metal (10) for the manufacture of said microcomponent (11), and finally an etching agent is introduced into the second group of free areas for the removal of the epoxy resist.

2. The process according to claim 1, wherein said adhesion layer (2) is structured prior to the deposition of said epoxy resist material (3).

3. The process according to claim 1, wherein said adhesion layer (2) is structured following the deposition of said epoxy resist material and removal of the non-irradiated areas (5) of said epoxy resist material (3).

4. The process according to claim 3, wherein said adhesion layer (2) is structured by plasma etching.

5. The process according to any of claims 1 to 4, wherein a polyimide material is used for said adhesion layer.

6. The process according to any of claims 1 to 5, wherein an epoxy derivative of a bis-phenol A novalac is used as said epoxy resist material, especially SU-8 Resist.

7. The process according to any of claims 1 to 6, wherein the thickness of the walls (7) of said support structures is chosen such that the aspect ratio of said walls is less than 20.

8. The process according to claim 7, wherein the thickness of the walls (7) of said support structures is chosen such that the aspect ratio is less than 10.

9. The process according to claim 1 to 8, wherein the thickness of all of said walls (7) is chosen to be the same.

## Revendications

1. Procédé lithographique de fabrication de micro-composants (1) avec des structures de composant dans le domaine inférieur au millimètre, avec lequel une couche adhésive (2) pouvant être structurée est appliquée sur une couche de départ (1) métallique et structurée et sur la couche adhésive (2) est appliquée une couche en résine époxy (3) pouvant être photo-structurée, la résine époxy (3) étant structurée au moyen d'une insolation sélective (4) et par enlèvement des zones non exposées (5) pour réaliser des structures de soutien (6) et des espaces libres (8, 9) entre les structures de soutien (6), ensuite les espaces libres (8) prévus pour le microcomposant (11) entre les structures de soutien en résine époxy (6) sont remplis de métal (10) par un procédé galvanique, et enfin la résine époxy (3) est éliminée, **caractérisé en ce que** lors de la structuration de la résine époxy (3) on réalise une structure en cadre (6) avec des parois d'appui (7) ainsi que deux groupes d'espaces libres (8, 9), ensuite on remplit de métal (10) uniquement le premier groupe d'espaces libres (8) pour réaliser le microcomposant (11), et enfin on introduit un décapant dans le deuxième groupe d'espaces libres (9) pour éliminer la résine époxy (3).

2. Procédé selon la revendication 1, **caractérisé en ce que** la couche adhésive (2) est structurée avant l'application de la résine époxy (3).

3. Procédé selon la revendication 1, **caractérisé en ce que** la couche adhésive (2) est structurée après l'application de la résine époxy (3) et élimination des zones non exposées (5) de la résine époxy (3).

4. Procédé selon la revendication 3, **caractérisé en ce que** la couche adhésive (2) est structurée par décapage au plasma.

5. Procédé selon l'une des revendications 1 à 4, **caractérisé en ce qu'**on utilise un polyimide pour la couche adhésive (2).

6. Procédé selon l'une des revendications 1 à 5, **caractérisé en ce qu'**on utilise comme résine époxy (3) un dérivé époxy d'un bis-phénol-A-novolac, en particulier un matériau SU8.

7. Procédé selon l'une des revendications 1 à 6, **caractérisé en ce que** l'épaisseur des parois (7) des structures de soutien (6) est choisie de manière que le rapport d'aspect des parois soit inférieur à 20.

8. Procédé selon la revendication 7, **caractérisé en ce que** l'épaisseur des parois (7) des structures de soutien (6) est choisie de manière que le rapport d'aspect soit inférieur à 10.

9. Procédé selon l'une des revendications 1 à 8, **caractérisé en ce qu'**on choisit la même épaisseur pour toutes les parois (7).
